# EUROPÄISCHE PATENTANMELDUNG

(11) **EP 2 158 997 A2**
(43) Veröffentlichungstag der Anmeldung: **03.03.2010**
(21) Anmeldenummer: 09010589.1
(22) Anmeldetag: 18.08.2009
(51) Int. Cl.: B23K 35/30, B23K 35/32, B23K 35/34, H05K 3/32, H01B 1/22

(54) **Steuerung der Porosität von Metallpasten für den druckfreien Niedertemperatursinterprozess**

(30) Priorität: 27.08.2008 DE 102008039828
(71) Anmelder: W.C. Heraeus GmbH, 63450 Hanau (DE)
(72) Erfinder: Schmitt, Wolfgang, 63110 Rodgau (DE); Schäfer, Michael, 36093 Künzell (DE); Hagedorn, Hans-Werner, 75196 Remching (DE)
(74) Vertreter: Kühn, Hans-Christian

(57) **Zusammenfassung**

Die vorliegende Erfindung ermöglicht es, sehr feste Schichten zwischen Kontaktflächen von Bauteilen zu erzeugen, die ausreichend elastisch sind, um mechanischen und thermischen Wechselbelastungen auf Dauer standzuhalten. Dies wird dadurch erreicht, dass die Porosität einer entsprechenden Kontaktstelle gesteuert wird. Dazu wird eine Metallpaste bereitgestellt, die 70 - 90 Gew.% eines Metallpulvers, 1-20 Gew.% einer endotherm zersetzbaren Metallverbindung und 5 - 20 Gew.% eines Lösungsmittels mit einem Siedepunkt von über 220°C enthält, wobei die Metallpaste exotherm zu einem Metallkontakt verdichtbar ist.

## Beschreibung

Die vorliegende Erfindung betrifft die Fügetechnik mit druck- und temperaturempfindlichen Bauteilen wie z.B. LED oder sehr dünnen Siliziumchips.

Beim Ankleben von druck- und temperaturempfindlichen Teilen ist die Kontaktstelle bezüglich Wärmeleitfähigkeit oder elektrischer Leitfähigkeit ungeeignet.

Herkömmliches Niedertemperatursintern scheidet wegen des dabei anzuwendenden hohen Drucks, der bis über 200 Bar betragen kann, aus. Außerdem müsste dazu ein hoher Aufwand betrieben werden, da der Durchsatz der produzierten Leistungsmodule von der Größe der Presse bestimmt würde und vor dem eigentlichen Sintern ein Trocknungsschritt durchgeführt werden müsste.

Gemäß der noch nicht veröffentlichten DE 10 2007 046 901 können sehr gut elektrisch und wärmeleitfähige Verbindungsschichten für die Leistungselektronik aufgebaut werden. Bei niedrigem Prozessdruck entstehen poröse Schichten.

Die Aufgabe der vorliegenden Erfindung besteht darin, sehr feste Schichten zwischen Kontaktflächen zu erzeugen, die ausreichend elastisch sind, um mechanischen und thermischen Wechselbelastungen auf Dauer standzuhalten und während der Verdichtung die Temperatur und den Prozessdruck gering zu halten.

Dies wird dadurch erreicht, dass die Porosität der entsprechenden Kontaktstelle gesteuert wird. Mit Flakes oder Pulvern, insbesondere auf Basis von Silber oder Kupfer, können ungefähr 83% des Volumens ausgefüllt werden, d. h. es verbleibt eine Porosität von ungefähr 17%. Die optimale Porosität für die höchste Festigkeit eines Kontakts hängt vom Material und den Anwendungsbedingungen der zu verbindenden Bauelemente ab. Erfindungsgemäß kann die Porosität der Kontaktstelle erhöht oder erniedrigt werden. Vorzugsweise wird die Porosität der Kontaktstelle jedoch erniedrigt. Durch das erfindungsgemäße Verfahren kann nicht nur eine Erniedrigung der Porosität der Kontaktstelle erreicht werden, sondern es wird außerdem gewährleistet, dass die Porosität gleichmäßig niedrig ist.

Zur Steuerung der Porosität der Kontaktstelle werden Metall-, insbesondere Silber- oder Kupferpasten zwischen Kontaktflächen exotherm verdichtet. Diese Verdichtung der Metallpaste erfolgt vorzugsweise im Rahmen eines Niedertemperatursinterprozesses durch in situ hergestelltes Metall, das eine Schließung von Lücken zwischen den Metallpartikeln der eingesetzten Metallpaste bewirkt. Die in situ-Metallherstellung erfolgt dabei durch die Zersetzung der in der Metallpaste enthaltenen Metallverbindung. Um eine möglichst hohe Verdichtung der Metallpaste zu erreichen, wird der exotherme Verdichtungsvorgang verzögert. Diese Verzögerung wird durch ein organisches Lösungsmittel mit einem Siedepunkt von über 220°C bewirkt. Durch diese Verzögerung bleibt dem in situ gebildeten Metall mehr Zeit, die Lücken zwischen den Metallpartikeln zu füllen. Auf diese Weise ist eine sehr dichte Verbindungsschicht (Kontaktstelle) bei sehr niedrigem Prozessdruck herstellbar, die hinsichtlich der Porosität sehr ähnlich ist wie die einer bei 200 Bar hergestellten Silberschicht aus einem endotherm verdichteten System.

Die Lösung der erfindungsgemäßen Aufgabe erfolgt mit den Merkmalen der unabhängigen Ansprüche. Die abhängigen Ansprüche beschreiben bevorzugte Ausführungen.

Dementsprechend wird durch die vorliegende Erfindung eine Metallpaste bereitgestellt, die 70 - 90 Gewichtsprozent eines Metallpulvers, 1 - 20 Gewichtsprozent einer endotherm zersetzbaren Metallverbindung und 5 - 20 Gewichtsprozent eines Lösungsmittels mit einem Siedepunkt von über 220°C, bezogen auf das Gewicht der Metallpaste, enthält, wobei die Metallpaste exotherm zu einem Metallkontakt verdichtbar ist.

Vorzugsweise sind in der Metallpaste 72 - 88 Gewichtsprozent, mehr bevorzugt 75 - 85 Gewichtsprozent und noch mehr bevorzugt 77 - 85 Gewichtsprozent des Metallpulvers, bezogen auf das Gewicht der Metallpaste, enthalten.

Der Anteil der endotherm zersetzbaren Metallverbindung beträgt vorzugsweise 3 - 18 Gewichtsprozent, mehr bevorzugt 4 -15 Gewichtsprozent und noch mehr bevorzugt 5 - 10 Gewichtsprozent, bezogen auf das Gewicht der Metallpaste.

Das Lösungsmittel mit einem Siedepunkt von über 220°C liegt in der erfindungsgemäßen Metallpaste vorzugsweise zu 9 - 20 Gewichtsprozent, mehr bevorzugt zu 10 - 20 Gewichtsprozent, noch mehr bevorzugt zu 11 - 20 Gewichtsprozent, bspw. zu 12 - 20 Gewichtsprozent oder auch zu 14 - 20 Gewichtsprozent, bezogen auf das Gewicht der Metallpaste, vor.

Neben dem Metallpulver, der endotherm zersetzbaren Metallverbindung und dem Lösungsmittel mit einem Siedepunkt von über 220°C können in der Metallpaste gegebenenfalls auch weitere Bestandteile vorhanden sein. Bspw. kann es bevorzugt sein, wenn in der Metallpaste weitere Lösungsmittel, zum Beispiel Lösungsmittel mit einem Siedepunkt von unter 220°C vorhanden sind. Hierfür kommen bspw. Terpineol, N-Methyl-2-pyrrolidon, Ethylenglycol, Dimethylacetamid oder unverzweigte oder verzweigte C5 - C9-Alkohole in Betracht. Diese weiteren Bestandteile können in der Metallpaste bspw. zu 0 - 25 Gewichtsprozent, bezogen auf das Gewicht der Metallpaste, enthalten sein. Allerdings kann es auch ausgeschlossen sein, dass in der Metallpaste neben dem Metallpulver, der endotherm zersetzbaren Metallverbindung und dem Lösungsmittel mit einem Siedepunkt von über 220°C weitere Bestandteile enthalten sind. Insbesondere kann es ausgeschlossen sein, dass neben dem Metallpulver, der endotherm zersetzbaren Metallverbindung und dem Lösungsmittel mit einem Siedepunkt von über 220°C weitere Lösungsmittel in der Metallpaste enthalten sind.

Als Metallpulver kommt im Rahmen der Erfindung grundsätzlich jedes Metallpulver in Betracht. Unter den als Bestandteil der Metallpaste beschriebenen Begriff "Metallpulver" können erfindungsgemäß auch Mischungen verschiedener Metallpulver, bspw. von Metallpulvern unterschiedlicher Zusammensetzung fallen. Das erfindungsgemäß verwendete Metallpulver enthält vorzugsweise Partikel, die wenigstens ein Metall, bspw. in elementarer Form, und/oder wenigstens eine Metalllegierung aufweisen. Es kann bevorzugt sein, dass die Partikel des Metallpulvers wenigstens 80 Gewichtsprozent, mehr bevorzugt wenigstens 90 Gewichtsprozent, noch mehr bevorzugt wenigstens 95 Gewichtsprozent, so zum Beispiel wenigstens 99 Gewichtsprozent oder 100 Gewichtsprozent, an Metall und/oder Metallverbindung aufweisen.

Die Partikel des eingesetzten Metallpulvers können beispielsweise wenigstens ein Metall aufweisen, das aus der Gruppe ausgewählt ist, die aus Kupfer, Silber, Gold, Nickel, Palladium, Platin und Aluminium besteht.

Die Partikel des eingesetzten Metallpulvers können statt oder zusätzlich zu den Metallen wenigstens eine Metalllegierung aufweisen. Bei der Legierung kann es sich beispielsweise um eine Kupfer- oder Edelmetallverbindung handeln. Vorzugsweise handelt es sich bei der Legierung um eine üblicherweise in Hartloten eingesetzte Legierung. Die Legierung enthält vorzugsweise wenigstens zwei Metalle, die aus der Gruppe ausgewählt sind, die aus Kupfer, Silber, Gold, Nickel, Palladium, Platin und Aluminium besteht. Es kann dabei bevorzugt sein, dass der Anteil der Elemente aus der Gruppe Kupfer, Silber, Gold, Nickel, Palladium, Platin und Aluminium an der Legierung wenigstens 90 Gewichtsprozent, vorzugsweise wenigstens 95 Gewichtsprozent, so zum Beispiel 100 Gewichtsprozent beträgt. Bei der Legierung kann es sich bspw. um eine Legierung aus Cu/Ag, Cu/Ag/Au, Cu/Au, Ag/Au, Ag/Pd, Pt/Pd oder Ni/Pd handeln. Als besonders geeignet erweisen sich im Rahmen der Erfindung Metallpulver aus Flakes oder Metallpulver aus Teilchen mit Größen im Bereich von 0,1 - 10 µm, vorzugsweise 0,3 - 3 µm.

Als endotherm zersetzbare Metallverbindung, die erfindungsgemäß eingesetzt werden kann, kommt grundsätzlich jede endotherm zersetzbare Metallverbindung in Betracht. Unter den als Bestandteil der Metallpaste beschriebenen Begriff "endotherm zersetzbare Metallverbindung" können erfindungsgemäß auch Mischungen verschiedener endotherm zersetzbarer Metallverbindungen, bspw. von endotherm zersetzbaren Metallverbindungen unterschiedlicher Zusammensetzung fallen. Erfindungsgemäß soll unter endotherm zersetzbarer Metallverbindung eine Metallverbindung verstanden werden, deren thermische Zersetzung, vorzugsweise unter Schutzgasatmosphäre, einen endothermen Vorgang darstellt. Bei dieser thermischen Zersetzung soll es zur Freisetzung von Metall aus der Metallverbindung kommen. Gemäß einer bevorzugten Ausführungsform weist die endotherm zersetzbare Metallverbindung ein Metall auf, das auch im Metallpulver enthalten ist. Vorzugsweise weist die endotherm zersetzbare Metallverbindung als Metall Kupfer, Silber, Gold, Nickel, Palladium oder Platin auf. Es kann bevorzugt sein, als endotherm zersetzbare Metallverbindungen endotherm zersetzbare Carbonate, Lactate, Formiate, Citrate, Oxide oder Fettsäuresalze (zum Beispiel mit C6 bis C24-Fettsäuren) der genannten Metalle zu verwenden. Als Beispiele für erfindungsgemäß einsetzbare endotherm zersetzbare Metallverbindungen seien Silbercarbonat, Silberlactat, Silberformiat, Silbercitrat, Silberoxid (zum Beispiel Ag₂O), Kupferlactat, Kupferstearat, Kupferoxide (zum Beispiel Cu₂O oder CuO) oder Goldoxide (zum Beispiel Au₂O oder AuO) genannt. Die in der Metallpaste enthaltene endotherm zersetzbare Metallverbindung weist vorzugsweise eine Zersetzungstemperatur von unter 400°C, mehr bevorzugt von unter 350°C und noch mehr bevorzugt von unter 300°C auf. Als besonders geeignet erweisen sich Flakes oder Pulver aus Teilchen mit Größen im Bereich von 0,1 - 10 µm, vorzugsweise 0,3 - 3 µm.

In der Metallpaste ist erfindungsgemäß ein Lösungsmittel mit einem Siedepunkt von über 220°C enthalten. Vorzugsweise weist dieses Lösungsmittel einen Siedepunkt von über 250°C auf. Gemäß einer bevorzugten Ausführungsform ist das in der Metallpaste enthaltene Lösungsmittel mit einem Siedepunkt von über 220°C ein endotherm entfernbares Lösungsmittel mit einem Siedepunkt von über 220°C. Unter endotherm entfernbarem Lösungsmittel wird erfindungsgemäß vorzugsweise ein Lösungsmittel verstanden, dessen Entfernung aus der Metallpaste einen endothermen Vorgang darstellt. Dies ist vorzugsweise zum Beispiel dann der Fall, wenn das Lösungsmittel während des Sinterprozesses mittels hierin beschriebener Metallpaste nicht abreagiert, also ohne eine Reaktion einzugehen, aus der Metallpaste entweichen kann. Im Rahmen der Erfindung fallen unter den Begriff "Lösungsmittel mit einem Siedepunkt von über 220°C" auch Mischungen verschiedener Lösungsmittel mit einem Siedepunkt von über 220°C. Bei dem Lösungsmittel mit einem Siedepunkt von über 220°C kann es sich beispielsweise um 1-Tridecanol, 2-Tridecanol, 3-Tridecanol, 4-Tridecanol, 5-Tridecanol, 6-Tridecanol, Isotridecanol, dibasische Ester (zum Beispiel Dimethylester der Glutar-, Adipin- oder Bernsteinsäure oder Mischungen davon), Glycerin, Diethylenglycol, Triethylenglycol oder Mischungen hiervon handeln.

Die Metallpaste ist erfindungsgemäß exotherm zu einem Metallkontakt verdichtbar. Dies ist dann gegeben, wenn sich die Verdichtung der Metallpaste zu einem Metallkontakt als exothermer Vorgang darstellt.

Gemäß einer bevorzugten Ausführungsform ist die erfindungsgemäße Metallpaste ohne Sauerstoffzufuhr exotherm zu einem Metallkontakt verdichtbar. Ohne Sauerstoffzufuhr bedeutet erfindungsgemäß, dass die Verdichtung in sauerstofffreier Atmosphäre erfolgt. Unter Sauerstofffreier Atmosphäre ist erfindungsgemäß eine Atmosphäre mit einem Sauerstoffgehalt von weniger als 1 % zu verstehen.

Weiterhin ist es bevorzugt, dass die Metallpaste einen Festkörperanteil von wenigstens 50 Volumenprozent aufweist.

Erfindungsgemäß kann die Metallpaste auch in Form einer Suspension vorliegen. In diesem Fall kann es bevorzugt sein, wenn neben dem Metallpulver, der endotherm zersetzbaren Metallverbindung und dem Lösungsmittel mit einem Siedepunkt von über 220°C ein weiteres Lösungsmittel enthalten ist. Bei dem weiteren Lösungsmittel kann es sich um ein Lösungsmittel mit einem Siedepunkt von unter 220°C handeln. Der Anteil des weiteren Lösungsmittels beträgt dann vorzugsweise 10 - 50 Gewichtsprozent. Die Summe der Gewichtsanteile von Metallpulver, endotherm zersetzbarer Metallverbindung und Lösungsmittel mit einem Siedepunkt von über 220°C beträgt in diesem Fall vorzugsweise 50 - 90 Gewichtsprozent. Es kann bevorzugt sein, wenn die Suspension 70 - 90 Gewichtsprozent des hierin beschriebenen Metallpulvers, 1 - 20 Gewichtsprozent der hierin beschriebenen endotherm zersetzbaren Metallverbindung und 5 - 20 Gewichtsprozent des hierin beschriebenen Lösungsmittels mit einem Siedepunkt von über 220°C, bezogen auf die Summe der Gewichtsanteile von Metallpulver, endotherm zersetzbarer Metallverbindung und Lösungsmittel mit einem Siedepunkt von über 220°C, bspw. von 50 - 90 Gewichtsprozent, in der Suspension enthält. Es kann jedoch auch bevorzugt sein, wenn in der Suspension der Anteil des Lösungsmittels mit einem Siedepunkt von über 220°C erhöht ist. In diesem Fall kann ggf. auch auf den Einsatz eines Lösungsmittels mit einem Siedepunkt von unter 220°C verzichtet werden. Gemäß einer bevorzugten Ausführungsform enthält die Suspension 35 - 81 Gewichtsprozent (vorzugsweise 50 - 70 Gewichtsprozent) Metallpulver, 0,5 - 18 Gewichtsprozent (vorzugsweise 3 - 15 Gewichtsprozent) endotherm zersetzbare Metallverbindung, 2,5 - 47 Gewichtsprozent (vorzugsweise 5 - 10 Gewichtsprozent) eines Lösungsmittels mit einem Siedepunkt von über 220°C und 0 - 50 Gewichtsprozent (vorzugsweise 0 - 20 Gewichtsprozent) eines weiteren Lösungsmittels.

Die Erfindung stellt außerdem ein Verfahren zum Zusammenfügen gegenüberliegender, insbesondere übereinander liegender Kontaktflächen bereit, bei dem die übereinander liegenden Kontaktflächen über die erfindungsgemäße Metallpaste oder die erfindungsgemäße Suspension miteinander kontaktiert werden und die Metallpaste oder Suspension exotherm verdichtet wird.

Das Zusammenfügen der Kontaktflächen durch exotherme Verdichtung der dazwischenliegenden Metallpaste erfolgt erfindungsgemäß vorzugsweise über einen Niedertemperatursinterprozess.

Die zusammenzufügenden Kontaktflächen sind vorzugsweise Bestandteil von wenigstens zwei zusammenzufügenden Bauelementen.

Somit betrifft die Erfindung auch ein Verfahren zur Verbindung von wenigstens zwei Bauelementen, die über die erfindungsgemäße Metallpaste oder die erfindungsgemäße Suspension miteinander kontaktiert werden und wobei die Metallpaste oder Suspension exotherm verdichtet wird. Die zu verbindenden Bauelemente sind dabei übereinander angeordnet. Eine solche Anordnung ist auch als Sandwich-Anordnung bekannt. Insbesondere sollen die zu verbindenden Bauelemente nicht nebeneinander auf einem gemeinsamen Träger angeordnet sein.

Demgemäß ist im Rahmen der Erfindung auch die Verwendung der hierin beschriebenen Metallpaste zur Verbindung von übereinander liegenden Bauelementen, vorzugsweise in einer Sandwich-Anordnung, zu einem Bauteil vorgesehen.

Im Folgenden soll der Begriff "Metallpaste" aus Gründen der besseren Lesbarkeit eine Suspension mit umfassen.

Bei den zu verbindenden Bauelementen kann es sich beispielsweise um Module und/oder Substrate handeln.

Gemäß einer bevorzugten Ausführungsform werden erfindungsgemäß wenigstens zwei Module, wenigstens zwei Substrate oder wenigstens ein Modul und wenigstens ein Substrat miteinander verbunden.

Beispielsweise kann es sich bei dem Modul um eine LED (light emitting diode, lichtemittierende Diode), einen Die, eine Diode, ein IGBT (insulated-gate bipolar transistor, Bipolartransistor mit isolierter Gate-Elektrode), einen IC (integrated circuit, integrierte Schaltung), einen Sensor, einen Kühlkörper (z.B. Aluminiumkühlkörper oder Kupferkühlkörper) oder ein anderes passives Baulement (zum Beispiel einen Widerstand, einen Kondensatoren oder eine Spule) handeln.

Das Substrat kann bspw. ein Leadframe, ein keramisches Substrat oder ein DCB (direct copper bonded)-Substrat sein.

Unter bevorzugten Ausführungsformen betrifft die Erfindung die Verbindung von LED mit Leadframe, von LED mit keramischem Substrat, von einem Modul ausgewählt aus Dies, Dioden, IGBTs und ICs, mit einem Substrat ausgewählt aus Leadframes, keramischen Substraten oder DCB-Substraten, von Sensor mit Leadframe oder keramischem Substrat, von DCB oder keramischem Substrat mit Kupfer- oder Aluminiumkühlkörper oder von Leadframe mit Kühlkörper.

Ebenfalls bevorzugt können erfindungsgemäß die einzelnen Elemente von Sandwichaufbauten miteinander verbunden werden. Beispielsweise können solche Sandwichaufbauten einen Aufbau umfassend (i) LED oder Chip, (ii) Leadframe und (iii) Kühlkörper aufweisen, wobei vorzugsweise der Leadframe mit dem LED oder Chip einerseits und mit dem Kühlkörper andererseits über die Metallpaste miteinander in Kontakt stehen. Ferner kann der Sandwichaufbau einen Aufbau umfassen, bei dem sich eine Diode zwischen zwei Kühlkörpern befindet, wobei vorzugsweise jeder der beiden Kühlkörper mit einer anderen Kontaktfläche der Diode über die Metallpaste verbunden ist.

Unter Kontaktfläche wird erfindungsgemäß diejenige Oberfläche eines Bauelements verstanden, die mit der erfindungsgemäßen Metallpaste in Kontakt steht.

Einzelne Oberflächen der zusammenzufügenden Bauelemente, vorzugsweise also Modul und Substrat, können eine Metallisierungsschicht umfassen. Diese Metallisierungsschicht kann einer Kontaktfläche entsprechen oder diese Kontaktfläche an der Oberfläche der Metallisierungsschicht enthalten.

Gemäß einer bevorzugten Ausführungsform kann die Metallisierungsschicht wenigstens ein Element aufweisen, das aus der Gruppe ausgewählt ist, die aus Kupfer, Silber, Gold, Palladium oder Platin besteht. Die Metallisierungsschicht kann auch aus diesen Elementen bestehen.

Andererseits kann die Metallisierungsschicht eine Legierung aufweisen, die wenigstens zwei Elemente enthält, die aus der Gruppe ausgewählt sind, die aus Silber, Gold, Nickel, Palladium und Platin besteht. Der Anteil dieser Elemente an der Legierung beträgt vorzugsweise 90 Gewichtsprozent, mehr bevorzugt wenigstens 95 Gewichtsprozent, noch mehr bevorzugt wenigstens 99 Gewichtsprozent, so zum Beispiel 100 Gewichtsprozent. Vorzugsweise enthält eine solche Legierung wenigstens zwei Elemente, die aus der Gruppe ausgewählt sind, die aus Silber, Palladium und Platin besteht. Die Metallisierungsschicht kann vorzugsweise wenigstens 95 Gewichtsprozent, mehr bevorzugt wenigstens 99 Gewichtsprozent und noch mehr bevorzugt 100 Gewichtsprozent dieser Legierung aufweisen.

Die Metallisierungsschicht kann auch einen mehrschichtigen Aufbau aufweisen. So kann es beispielsweise bevorzugt sein, wenn wenigstens eine Oberfläche der zusammenzufügenden Bauelementen bspw. mehrere Schichten umfasst, die die vorstehend genannten Elemente und/oder Legierungen aufweisen. Gemäß einer bevorzugten Ausführungsform umfasst wenigstens eine Oberfläche eines Bauelements, bspw. eines DCB-Substrats, eine Kupferschicht, auf der eine Schicht aus Nickel aufgebracht ist. Ggf. kann auf der Nickelschicht nochmals eine Schicht aus Gold aufgebracht sein. Die Dicke der Nickelschicht beträgt vorzugsweise 1 - 2 µm und die Dicke der Goldschicht vorzugsweise 0,05 - 0,3 µm. Andererseits kann es auch bevorzugt sein, wenn eine Oberfläche eines Bauelements eine Schicht aus Silber oder Gold und darüber eine Schicht aus Palladium oder Platin umfasst. Gemäß einer weiteren bevorzugten Ausführungsform enthalten die einzelnen Schichten neben den genannten Elementen oder Legierungen auch ein Glas. Es kann auch bevorzugt sein, wenn die Schichten eine Mischung aus (i) Glas und (ii) den Elementen oder Legierungen darstellen.

In diesem Zusammenhang kann es beispielsweise bevorzugt sein, dass ein LED eine Metallisierungsschicht aus Silber oder eine Beschichtung aus Nickel und Gold, ein Chip eine Metallisierungsschicht aus Silber oder eine Beschichtung aus Nickel und Gold, ein Leadframe eine Metallisierungsschicht aus Kupfer oder Silber oder eine Beschichtung aus Nickel und Gold, ein DCB-Substrat eine Metallisierungsschicht aus Kupfer oder Silber oder eine Beschichtung aus Nickel und Gold, keramische Substrate eine Metallisierungsschicht aus Silber, Gold, Palladium, Platin, einer Silber-Palladium-Legierung oder einer Silber-Platin-Legierung und ein Kühlkörper eine Metallisierungsschicht aus Kupfer, Silber oder eine Beschichtung aus Nickel und Gold aufweist.

Im Rahmen des erfindungsgemäßen Verfahrens werden die zusammenzufügenden Bauelemente über die erfindungsgemäße Metallpaste miteinander in Kontakt gebracht.

Dazu wird zunächst ein Aufbau hergestellt, der wenigstens zwei Bauelemente umfasst, die über die erfindungsgemäße Metallpaste miteinander kontaktiert werden. Vorzugsweise geschieht dies dadurch, dass zunächst eine Oberfläche eines Bauelements mit der Metallpaste versehen und ein anderes Bauelement mit einer seiner Oberflächen auf die Metallpaste aufgesetzt wird.

Die Auftragung der Metallpaste auf die Oberfläche eines Bauelements kann bspw. mittels herkömmlicher Verfahren, wie Druckverfahren (zum Beispiel Siebdruck oder Schablonendruck), der Dispenstechnik, der Spraytechnik, durch Pintransfer oder durch Dippen erfolgen.

Im Anschluss daran wird vorzugsweise die mit der Metallpaste versehene Oberfläche dieses Bauelements mit einer Oberfläche des zu verbindenden Bauelements über die Metallpaste in Kontakt gebracht. Somit befindet sich zwischen den zusammenzufügenden Bauelementen eine Schicht Metallpaste. Die sich gegenüberliegenden Oberflächen der Bauelemente, die mit der Metallpaste in Kontakt stehen, sind erfindungsgemäß die Kontaktflächen der beiden Bauelemente.

Die Nassschichtdicke zwischen den zusammenzufügenden Bauelementen, die gemessen wird als der Abstand zwischen den sich gegenüberliegenden Kontaktflächen der zu verbindenden Bauelemente vor dem Sinterprozess, liegt vorzugsweise im Bereich von 20 - 200 µm. Die bevorzugte Nasssichtdicke ist abhängig vom gewählten Auftrageverfahren. Wird die Metallpaste mittels Siebdruckverfahren aufgetragen, dann kann eine Nassschichtdicke von 20 - 50 µm bevorzugt sein. Erfolgt die Auftragung der Metallpaste mittels Schablonendruck, dann kann die bevorzugte Nassschichtdicke im Bereich von 50 - 200 µm liegen.

Gegebenenfalls wird der so erhaltene Aufbau vor dem Niedertemperatursinterprozess getrocknet. Die Trocknungstemperatur liegt vorzugsweise im Bereich von 50 - 100°C. Es versteht sich, dass die Trocknungszeit abhängig ist von der jeweiligen Zusammensetzung und der Bauteilgröße. Andererseits kann die Trocknung auch bereits unmittelbar nach dem Auftragen der Metallpaste auf die wenigstens eine Oberfläche des Bauelements und vor der Kontaktierung mit dem zu verbindenden Bauelement erfolgen.

Der Aufbau aus den wenigstens zwei Bauelementen, die über die Metallpaste miteinander in Kontakt stehen, wird anschließend vorzugsweise einem Niedertemperatursinterprozess unterzogen. Dabei kommt es zur hierin beschriebenen exothermen Verdichtung der Metallpaste.

Unter Niedertemperatursinterprozess ist erfindungsgemäß ein Sinterprozess zu verstehen, der vorzugsweise bei einer Temperatur im Bereich von 230 - 350°C, mehr bevorzugt im Bereich von 250 - 300°C, abläuft.

Der Prozessdruck liegt dabei vorzugsweise im Bereich von 0 - 200 bar, mehr bevorzugt im Bereich von 1 - 50 bar.

Die Sinterzeit ist abhängig vom Prozessdruck und liegt vorzugsweise im Bereich von 2 - 45 Minuten. Die Sinterzeit liegt bei einem Prozessdruck von 0 - 2 bar, zum Beispiel 0 bar, vorzugsweise im Bereich von 20 - 45 Minuten, bei einem Prozessdruck von 5 - 15 bar, zum Beispiel 10 bar, vorzugsweise im Bereich von 15 - 30 Minuten, bei einem Prozessdruck von 40 - 60 bar, zum Beispiel 50 bar, vorzugsweise im Bereich von 10 - 20 Minuten und bei einem Prozessdruck von 180 - 200 bar, zum Beispiel 200 bar, vorzugsweise im Bereich von 2 - 5 Minuten.

Erfindungsgemäß kann die Porosität der Kontaktstellen zwischen den zu verbindenden Bauelementen gezielt gesteuert werden. Da die Bauelemente unterschiedlich empfindlich hinsichtlich Temperatur, Druck und Zeit sind, ist es notwendig, die Porosität über die Metallpaste zu steueren.

Diese Steuerung lässt sich insbesondere durch den Anteil des Lösungsmittels mit einem Siedepunkt von über 220°C in der eingesetzten Metallpaste erreichen.

Je höher bspw. der Anteil des Lösungsmittels mit einem Siedepunkt von über 220°C in der Metallpaste gewählt wird, desto länger ist der Zeitraum, in dem beim Niedertemperatursinterprozess der exotherme Verdichtungsvorgang erfolgt. Somit steht dem in der Metallpaste beim Niedertemperatursinterprozess in situ aus der endotherm zersetzbaren Metallverbindung erzeugten Metall mehr Zeit zur Verfügung, um die Lücken zwischen den Metallpartikeln der eingesetzten Metallpaste aufzufüllen. Dies hat eine Erniedrigung der Porosität der Kontaktstelle zwischen den zu verbindenden Bauelementen zur Folge.

Andererseits kann die Porosität der Kontaktstelle durch Erniedrigung des Anteils des Lösungsmittels mit einem Siedepunkt von über 220°C in der Metallpaste auch erhöht werden.

Erfindungsgemäß wird daher eine Metallpaste, die ein Metallpulver, eine endotherm zersetzbare Metallverbindung und ein Lösungsmittel mit einem Siedepunkt von über 220°C enthält, zur Steuerung der Porosität einer Kontaktstelle zwischen zu verbindenden Bauelementen in einem Niedertemperatursinterprozess verwendet.

Vorzugsweise handelt es sich bei der Metallpaste um die vorstehend beschriebene Metallpaste, die 70 - 90 Gewichtsprozent eines Metallpulvers, 1 - 20 Gewichtsprozent einer endotherm zersetzbaren Metallverbindung und 5 - 20 Gewichtsprozent eines Lösungsmittels mit einem Siedepunkt von über 220°C enthält.

Dementsprechend wird auch ein Verfahren zur Steuerung der Porosität einer Kontaktstelle zwischen zwei Bauelementen zur Verfügung gestellt, wobei man einen Aufbau, der zwei Bauelemente umfasst, die durch eine Metallpaste miteinander verbunden sind, einem Niedertemperatursinterprozess unterzieht, **dadurch gekennzeichnet, dass** die Metallpaste ein Metallpulver, eine endotherm zersetzbare Metallverbindung und ein Lösungsmittel mit einem Siedepunkt von über 220°C umfasst, und der Anteil des Lösungsmittels mit einem Siedepunkt von über 220°C so eingestellt wird, dass die gewünschte Porosität der Kontaktstelle erreicht wird.

Mit dem beschriebenen Verfahren lässt sich ein Bauteil herstellen, das wenigstens zwei übereinander (insbesondere in einer Sandwich-Struktur) angeordnete Bauelemente umfasst, die durch eine exotherm verdichtete Metallpaste, wie sie vorstehend definiert ist, miteinander verbunden sind. Das Bauteil weist somit erfindungsgemäß Kontaktflächen auf, die durch eine verdichtete Metallpaste oder Suspension, wie sie hierin beschrieben ist, verbunden sind.

Erfindungsgemäß wird das Metall einer Metallpaste oder Suspension, die neben dem Metallpulver als Hauptkomponente eine endotherm zersetzbare Metallverbindung und ein endotherm entfernbares Lösungsmittel enthält, verdichtet, wobei die Verdichtung letztlich durch die endotherme Zersetzung der Metallverbindung gesteuert wird.

Vorzugsweise wird bei der Erzeugung einer Kontaktstelle durch Zusammenfügen gegenüberliegender Metallflächen mittels Kontaktpaste, die Metallpartikel und eine zersetzbare Verbindung eines Metalls aufweist, das aus der Gruppe Silber, Kupfer, Aluminium, Nickel und Palladium ausgewählt ist, die Paste während der Zersetzung der Metallverbindung exotherm zu einer niederporösen Befestigungsmasse umgesetzt.

Die exotherme Reaktion der Metallverbindung kann durch Gegenwart eines organischen Lösungsmittels zeitlich gesteuert werden, das einen Siedepunkt von über 220°C, insbesondere von über 250°C aufweist.

Die exotherme Reaktion kann dabei in einem Zeitraum von 10 Sekunden bis zu 10 Minuten aufrechtgehalten werden

Erfindungsgemäß vorgesehen ist, dass das Lösungsmittel während der Zersetzung der Metallverbindung entfernt wird. Andererseits kann auch während der Entfernung des Lösungsmittels die Zersetzung der Metallverbindung erfolgen.

Somit wird erfindungsgemäß die Porosität der erzeugten Füge- bzw. Kontaktschicht, insbesondere auf Basis von Silber oder Kupfer dadurch verringert, dass zwischen den Flakes oder Pulverkörnern in situ hergestelltes Metall, insbesondere Silber oder Kupfer die Lücken füllt. In erfindungsgemäßer Weiterbildung wird der exotherme Prozess verlängert, so dass die Schließung der Lücken kontinuierlich erfolgt. Diese zeitliche Verzögerung der exothermen Reaktion wird mit einem organischen Lösungsmittel bewirkt, das einen hohen Siedepunkt aufweist. Die Anwendung eines derartigen Lösungsmittels ermöglicht die Steuerung der Porosität. Lösungsmittel mit einem Siedepunkt bis 200°C kommen hierfür nicht in Frage. Sie verdampfen zu schnell, so dass die exotherme Reaktion schlagartig verläuft. Lösungsmittel mit einem Siedepunkt von über 220°C erlauben bereits die Verlängerung der exothermen Reaktion auf über 10 Sekunden. Lösungsmittel mit einem Siedepunkt über 250°C ermöglichen die Verlängerung der exothermen Reaktion bis zu 10 Minuten. Hierbei bedingen miteinander einhergehend die langsame Bildung von Silber und das langsame Verdampfen der organischen Komponenten eine maßgebliche Reduzierung der Poren und deshalb eine höhere Verdichtung. Hierzu wird erfindungsgemäß eine Metallpaste bereitgestellt, die 1 bis 20, insbesondere 2 bis 10 Gewichts-% einer endotherm zersetzlichen Metallverbindung, insbesondere Silberverbindung wie Ag₂CO₃ aufweist, 5 bis 20 Gewichtsprozent, vorzugsweise 9 bis 20 Gewichtsprozent eines Lösungsmittels mit einem Siedepunkt über 220°C, insbesondere über 250°C, wie beispielsweise TDA, 0 bis 10 Gewichts-% üblicher Hilfsstoffe für Silberpasten wie z. B: Terpineol, und mindestens 60 Gewichts-% Silberpartikel.

Die Hauptkomponenten der Paste sind demgemäß Metall-, insbesondere Silber oder Kupferpartikel, die bei der bestimmungsgemäßen Anwendung der Paste zu einem dichten Gefüge zusammengefügt werden. Bei einem zu hohen Metallpartikelanteil, z.B. einem Gewichtsverhältnis von über 90 Gewichts-% Silberpartikel gehen die Pasteneigenschaften verloren. Bei einem zu geringen Metallpartikelanteil, z.B. einem Anteil von unter 60 Gewicht-% Silberpartikel verbleibt eine zu große Porosität der Fügestelle. Zur Vernetzung der Metallpartikel, insbesondere Silberpartikel wird die endotherm zersetzende Metallverbindung, insbesondere Silberverbindung in einem in einer Differential-Thermo-Analyse (DTA) exotherm erscheinenden Prozess angewendet. Das aus der endothermen Metall-, insbesondere Silberverbindung entstehende Metall, insbesondere Silber verbindet die Metall- insbesondere Kupfer oder Silberteilchen und füllt die Lücken zwischen den Metall- insbesondere Kupfer- oder Silberteilchen. Bei zu wenig endothermer Metallverbindung z.B. einem Anteil von weniger als 1 Gewichts-% Silberverbindung in der Paste können die Poren der Fügeschicht nicht ausreichend reduziert werden und deshalb die Festigkeit nicht in der erfindungsgemäß möglichen Qualität erzielt werden. Bei einem zu hohen Anteil an der endothermen Verbindung, z.B. einem Anteil von über 20 Gewichts-% Silberverbindung, ist die exotherme Reaktion nur noch schwer steuerbar und es besteht die Gefahr, dass aufgrund einer zu heftigen kurzen Reaktion die Poren nicht effizient gefüllt werden oder andererseits die Reaktionszeit ungebührlich lange dauert, was den Prozess für die Massenproduktion unwirtschaftlich macht. Wenn der Anteil des hochsiedenden Lösungsmittels zu gering ist, insbesondere weniger als 5 Gewichts-% beträgt, kann die exotherme Reaktionsführung nicht lange genug verzögert werden, so dass keine gesteuerte Verringerung der Poren erfolgt. Wird dagegen das hochsiedende Lösungsmittel als Hauptkomponente eingesetzt, steht dessen Entfernung einer ausreichenden Verringerung der Porosität entgegen.

Als Metallpartikel eignen sich Flakes oder Pulver mit Partikelgrößen im µm-Bereich auf Basis von Kupfer, Edelmetallen, Nickel oder Aluminium und ineinander gut lösliche Mischungen davon wie Cu/Ag, Cu/Ag/Au, Cu/Au, Ag/Au, Ag/Pd, Pt/Pd und Ni/Pd. Silberhaltige Mischungen sind vorzugsweise nickelfrei. Ganz entsprechend eignen sich Systeme aus Partikeln und Metallverbindungen, wenn das aus der Metallverbindung freigesetzte Metall gut löslich mit dem Metall der Partikel ist. Vorzugsweise löst sich das aus der Metallverbindung freigesetzte Metall während der exothermen Verdichtung an den Metallpartikeln ohne Bildung neuer Phasen. Als endotherm zersetzbare Metallverbindungen eignen sich weit unter dem Schmelzpunkt Ihrer Metalle zersetzliche Verbindungen. Dies trifft für viele Edelmetallverbindungen zu. Bei Kupferverbindungen ist zu beachten, ob diese toxisch sind oder ob ggf. Toxizität tolerierbar ist. Vorzugsweise setzt die Zersetzung der zersetzlichen Metallverbindung noch während der Entfernung des hochsiedenden Lösungsmittels ein. Zersetzungstemperaturen unter 400°C, insbesondere unter 350° ermöglichen die Verwendung organischer Lösungsmittel. Für besonders sensible Anwendungen der Halbleitertechnik werden Metallverbindungen mit Zersetzungstemperaturen unter 300°C angewendet. Bei Zersetzungstemperaturen unter 300°C werden übliche Weichlotverfahren ersetzt.

Die Partikel sollen beim Lagern nicht agglomerieren. Deshalb sind Nanopulver im Allgemeinen nicht vorteilhaft, obwohl möglichst kleine Partikel bevorzugt werden. Bewährt haben sich 0,2-10 µm insbesondere 0,3 -3 µm große Partikel, insbesondere gewalzte Partikel (Flakes) mit großer Oberflächenrauigkeit.

Das erfindungsgemäße exotherme Verdichten ist im Gegensatz zu vielen Sinterverfahren unter Schutzgas durchführbar. Beim Kontaktieren mit der Paste werden die Metalloberflächen der zu verbindenden Teile unter Schutzgas nicht oxidiert. Deshalb werden mit der Paste zuverlässige Fügestellen geschaffen. Mit der Paste unter Schutzgas hergestellte Metallisierungen auf elektrischen Bauteilen sind ohne Weiterbehandlung verbindbar, insbesondere bondbar. Für das erfindungsgemäße exotherme Verdichten ist keine Sauerstoffquelle erforderlich.

Im Folgenden wird die Erfindung anhand von Zeichnungen verdeutlicht.

Figur 1 verdeutlicht das Prinzip der Erfindung anhand eines Flussdiagramms gegenüber einem bekannten Sinterprozess von Silberpasten ohne Silberverbindungen.

Figur 2a-d zeigt den Einfluss eines hochsiedenden Lösungsmittels auf die Peakbreite der exothermen Verdichtung.

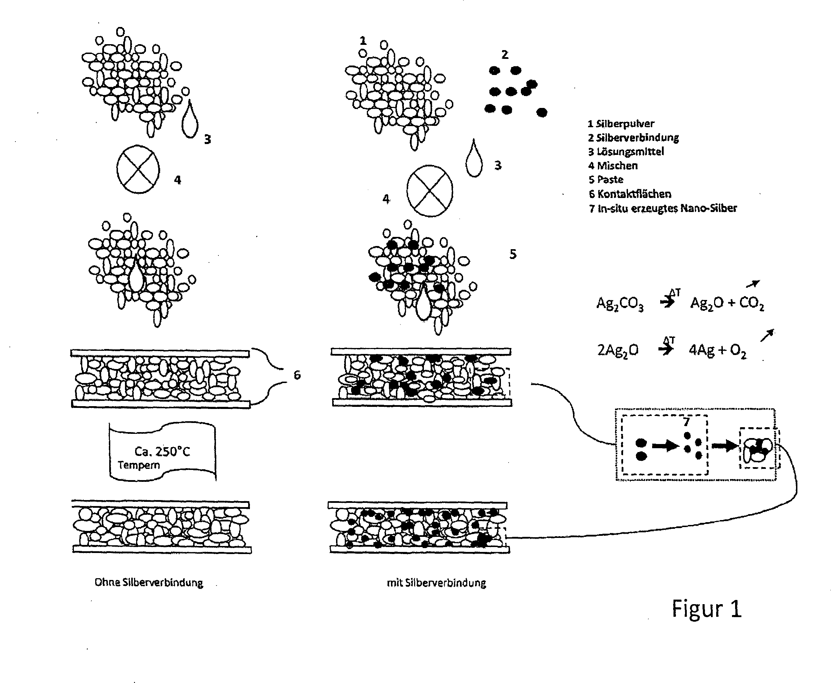

Figur 1 verdeutlicht das Verdichten, bei dem Silber und Silberkarbonat gemischt und mit Lösungsmittel zu einer Paste verarbeitet werden. Das zwischen den Silberpartikeln der Paste angeordnete Silbercarbonat wird druckfrei bei 250°C in reaktives Silber und CO₂ zersetzt wobei das reaktive Silber die Lücken zwischen den Silberpartikeln füllt und die Silberpartikel verfestigt. Auf diese Weise wird ein Silberkontakt mit geringer Porosität erzeugt. Analog wird das Silber auf der Substratoberfläche befestigt. Gegenüber bekannten, in der Fügetechnik erzeugten Silberkörpern mit einer Porosität von ungefähr 17 Volumen-% lässt sich die Porosität erfindungsgemäß auf unter 10 Vol.% begrenzen.

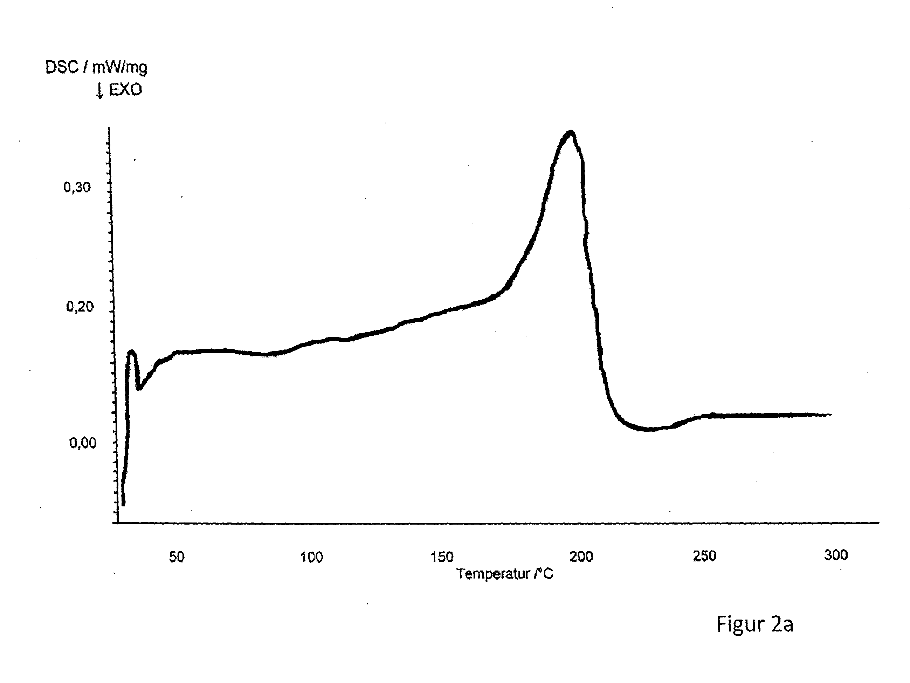

Gemäß Fig. 2a-d wird die Dauer der exothermen Verdichtung über den Anteil an hochsiedendem Lösungsmittel in der Paste gesteuert. Eine Verlangsamung der exothermen Verdichtung führt zu einer porenärmeren Fügestelle einhergehend mit verbesserter mechanischen, elektrischen und thermischen Leitfähigkeit.

Eine Paste aus 78 Gewichtsprozent Silber, 5 Gewichtsprozent Silbercarbonat und 17 Gewichtsprozent Terpineol (Sdp. 219°C) zeigt in einer unter Schutzgas ausgeführten Differential-Thermo-Analyse gemäß Fig. 2a einen endothermen Peak bei 200°C. Die Paste agglomeriert bereits zu einer mechanisch nicht belastbaren porösen Masse.

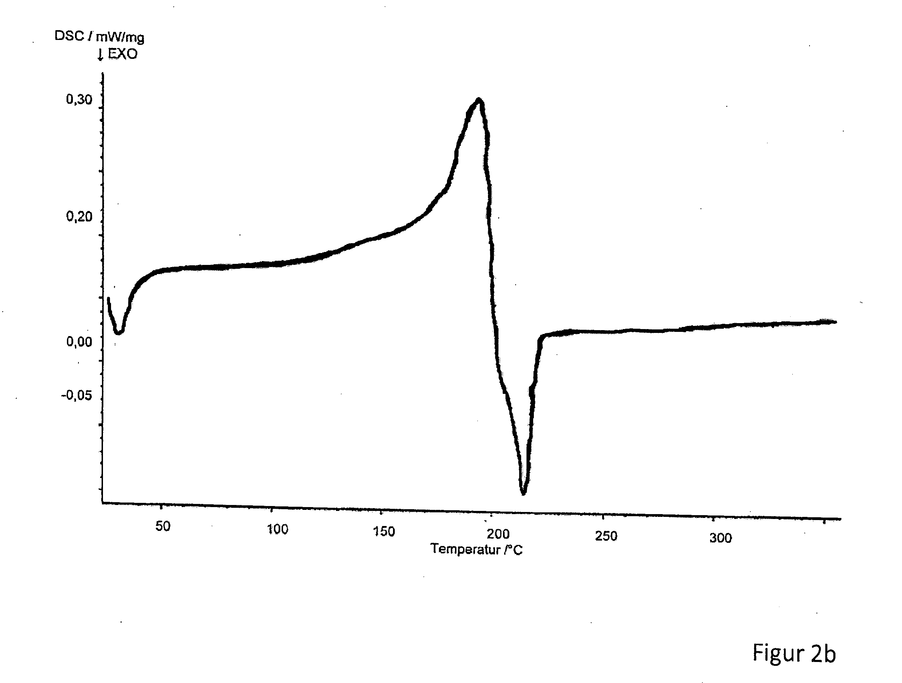

Eine Paste aus 83 Gewichtsprozent Silber, 5 Gewichtsprozent Silbercarbonat und 12 Gewichtsprozent Terpineol (Sdp. 219°C) zeigt in einer unter Schutzgas ausgeführten Differential-Thermo-Analyse gemäß Fig. 2b nach dem endothermen Peak bei 200°C einen exothermen Peak. Die Paste agglomeriert ebenfalls zu einer mechanisch nicht belastbaren porösen Masse.

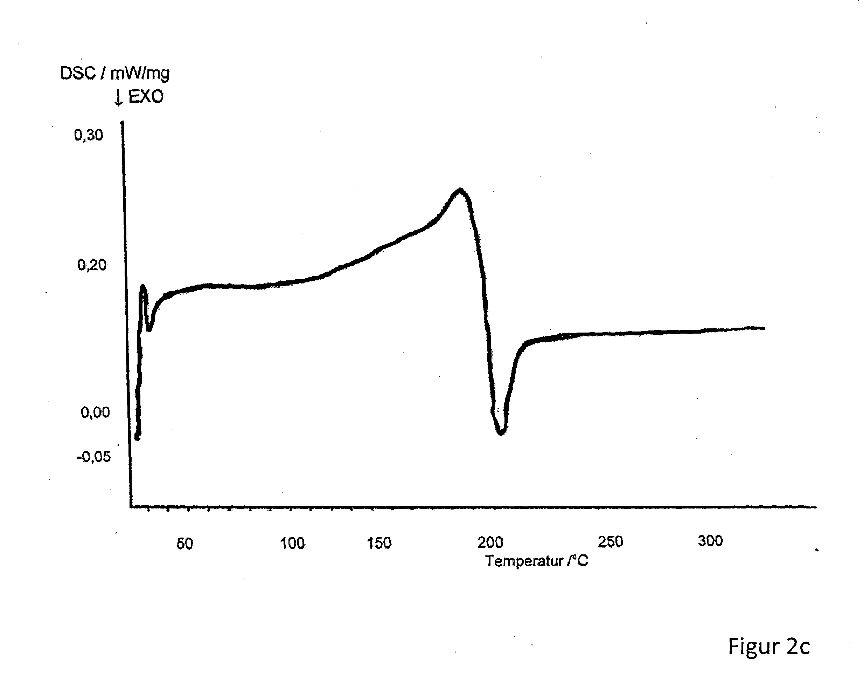

Eine Paste aus 83 Gewichtsprozent Silber, 5 Gewichtsprozent Silbercarbonat und 10 Gewichtsprozent Terpineol (Sdp. 219°C) und 2 Gewichtsprozent 1-Tridecanol (Tridecylalkohol: TDA; Sdp. 274 -280°C) führt in einer unter Schutzgas ausgeführten Differential-Thermo-Analyse gemäß Fig. 2c zu gegenüber Fig. 2b verschobenen und gestauchten Peaks bei 200°C. Die Paste agglomeriert ebenfalls zu einer mechanisch nicht belastbaren porösen Masse.

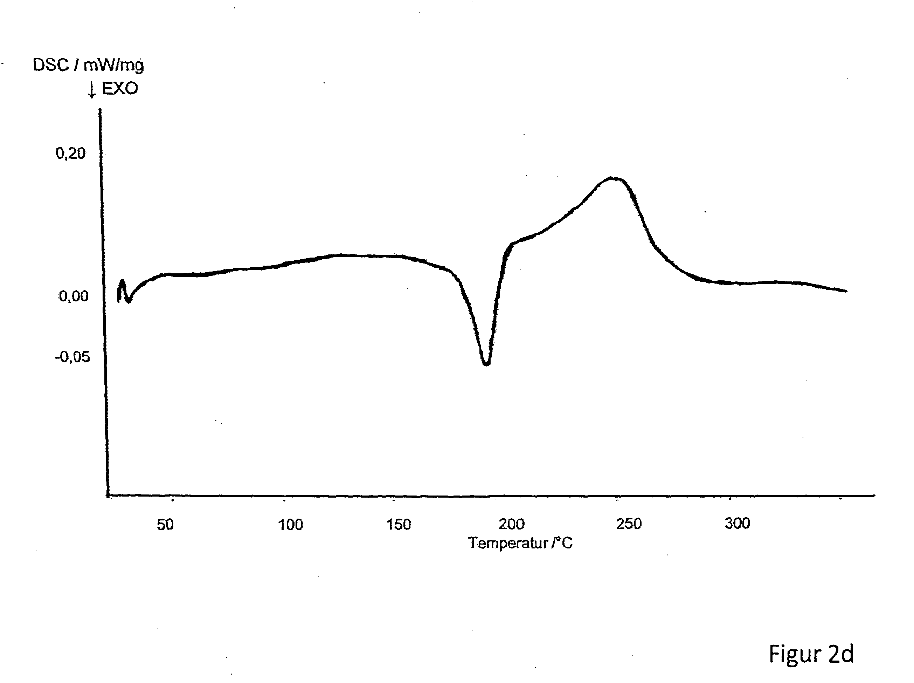

Eine Paste aus 83 Gewichtsprozent Silber, 5 Gewichtsprozent Silbercarbonat und 12 Gewichtsprozent 1-Tridecanol (TDA; Sdp. 274-280°C) führt in einer unter Schutzgas ausgeführten Differential-Thermo-Analyse gemäß Fig. 2d zu einem exothermen Peak unter 200°C. Die Paste agglomeriert dort zu einer mechanisch festen, porenarmen Masse, die mechanischen und thermischen Wechselbelastungen in der Leistungselektronik standhält, insbesondere LED Attach, Kontaktierung sehr kleiner Chips mit bis zu 4 x 4 mm. Die Porosität ist durch Variation der Menge an hochsiedendem Lösungsmittel in der Paste steuerbar und damit für spezielle Anwendungen genau einstellbar.

Die folgenden Ausführungsbeispiele sollen die Erfindung verdeutlichen:

### Beispiel 1:

Eine Metallpaste, die 83 Gewichtsprozent Silber, 5 Gewichtsprozent Silbercarbonat und 12 Gewichtsprozent 1-Tridecanol enthielt, wurde auf eine Oberfläche eines Leadframes gedruckt. Im Anschluss daran wurde ein Die mit einer Fläche von 8 mm² auf die Metallpaste gesetzt. Die Nassschichtdicke betrug 50 µm. Danach wurde der so erhaltene Aufbau für 20 Minuten bei 100°C getrocknet. Das Sintern erfolgte bei einem Prozessdruck von 0 bar und einer Prozesstemperatur von 250°C für eine Dauer von 45 Minuten.

### Beispiel 2:

Eine Metallpaste, die 83 Gewichtsprozent Silber, 5 Gewichtsprozent Silbercarbonat und 12 Gewichtsprozent 1-Tridecanol enthielt, wurde auf eine Oberfläche eines Leadframes mittels Dispenstechnik aufgebracht. Im Anschluss daran wurde eine LED mit einer Fläche von 9,2 mm² auf die Metallpaste gesetzt. Die Nassschichtdicke betrug 50 µm. Danach wurde der so erhaltene Aufbau für 20 Minuten bei 100°C getrocknet. Das Sintern erfolgte bei einem Prozessdruck von 0 bar und einer Prozesstemperatur von 250°C für eine Dauer von 45 Minuten.

## Patentansprüche

1. Metallpaste, enthaltend 70 - 90 Gew.% eines Metallpulvers, 1 - 20 Gew.% einer endotherm zersetzbaren Metallverbindung und 5 - 20 Gew.% eines Lösungsmittels mit einem Siedepunkt von über 220°C, wobei die Metallpaste exotherm zu einem Metallkontakt verdichtbar ist.

2. Metallpaste nach Anspruch 1, **dadurch gekennzeichnet, dass** die Metallpaste 11 -20 Gew.% eines Lösungsmittels mit einem Siedepunkt von über 220°C enthält.

3. Metallpaste nach Anspruch 1 oder 2, **dadurch gekennzeichnet, dass** die endotherm zersetzbare Metallverbindung eine Kupfer- oder Edelmetallverbindung ist.

4. Metallpaste nach einem der Ansprüche 1 - 3, **dadurch gekennzeichnet, dass** das Metallpulver überwiegend Silber oder Kupfer oder Gold oder Palladium oder Platin aufweist.

5. Metallpaste nach einem der Ansprüche 1 bis 4, **dadurch gekennzeichnet, dass** die Metallpaste ohne Sauerstoffzufuhr exotherm zu einem Metallkontakt verdichtbar ist.

6. Metallpaste gemäß einem der Ansprüche 1 - 5 in Form einer Suspension.

7. Verfahren zum Zusammenfügen gegenüberliegender Kontaktflächen, **dadurch gekennzeichnet, dass** die Kontaktflächen über eine Metallpaste gemäß einem der Ansprüche 1 - 6 miteinander kontaktiert werden und die Metallpaste exotherm verdichtet wird.

8. Verfahren nach Anspruch 8, **dadurch gekennzeichnet, dass** das in der Metallpaste vorhandene Lösungsmittel einen Siedepunkt von über 250°C aufweist.

9. Verfahren nach Anspruch 8, **dadurch gekennzeichnet, dass** die in der Metallpaste enthaltene Metallverbindung eine Zersetzungstemperatur von unter 400°C, vorzugsweise unter 350°C, besonders bevorzugt unter 300°C aufweist.

10. Bauteil, aufweisend übereinander angeordnete Bauelemente, die durch eine verdichtete Metallpaste nach einem der Ansprüche 1 - 6 verbunden sind.
